(19)

Europäisches
Patentamt
European
Patent Office
Office européen
des brevets

(11) **EP 2 940 780 A2**

(12) **EUROPEAN PATENT APPLICATION**

(43) Date of publication:
**04.11.2015 Bulletin 2015/45**

(51) Int Cl.:
***H01M 10/48*** *(2006.01)*    ***B60L 11/18*** *(2006.01)*
***G01R 31/36*** *(2006.01)*

(21) Application number: **15165929.9**

(22) Date of filing: **30.04.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **02.05.2014 KR 20140053555**

(71) Applicant: **Samsung SDI Co., Ltd.
Gyeonggi-do 446-902 (KR)**

(72) Inventors:
• **Ahn, Gi-Jang
446-902 Yongin-si, Gyeonggi-do (KR)**
• **Cheong, Kyeong-Beom
446-902 Yongin-si, Gyeonggi-do (KR)**

(74) Representative: **Gulde & Partner
Patent- und Rechtsanwaltskanzlei mbB
Wallstraße 58/59
10179 Berlin (DE)**

(54) **BATTERY MANAGEMENT APPARATUS**

(57)    A battery management apparatus to manage a battery in a vehicle includes a temperature detector that detects a temperature of the battery, a current detector that detects a current of the battery, a calculation unit that calculates a first degradation capacity using the detected temperature of the battery at every unit time while the vehicle is driven and that calculates a second degradation capacity using the detected temperature and state of charge (SOC) of the battery at every unit time while the vehicle is parked, and a determination unit that calculates a state of health (SOH) of the battery using the first and second degradation capacities so as to determine a replacement time of the battery according to the calculated SOH.

EP 2 940 780 A2

**Description**

BACKGROUND

1. Field

Embodiments relate to a battery management apparatus, and more particularly, to a battery management apparatus of a vehicle battery.

2. Description of the Related Art

Vehicles using gasoline or diesel as a primary fuel may cause environmental pollution such as air pollution and the like.
Electric vehicles, such as hybrid vehicles, etc., are being developed to utilize electrical energy outputted from a battery as a power source.

SUMMARY

Embodiments are directed to a battery management apparatus to manage a battery in a vehicle. The battery management apparatus includes a temperature detector that detects a temperature of the battery, a current detector that detects a current of the battery, a calculation unit that calculates a first degradation capacity using the detected temperature of the battery at every unit time while the vehicle is driven and that calculates a second degradation capacity using the detected temperature and state of charge (SOC) of the battery at every unit time while the vehicle is parked, and a determination unit that calculates a state of health (SOH) of the battery using the first and second degradation capacities so as to determine a replacement time of the battery according to the calculated SOH.
The calculation unit may calculate the first degradation capacity according to the following Equation 1:

Equation 1]

$$Qd = Bd \times e^{-\frac{Ea}{R \times Tb}} \times t^{n}$$

where Bd denotes a slope of a function showing a degradation degree of a standard capacity of the battery according to a varying temperature of the battery, Ea is an activation energy corresponding to a current temperature of the battery, Tb is a temperature of the battery while the vehicle is driven, R is a gas constant, t is time, and n is a constant that is predetermined by a degradation speed of the battery according to time.
The calculation unit may calculate the second degradation capacity according to the following Equation 2:

[Equation 2]

$$Qp = Bp \times e^{-\frac{Ea}{R \times Tb}} \times t^{n}$$

where Bp is a function with the SOC of the battery as a variable, Ea is an activation energy corresponding to a current temperature of the battery, Tb is a temperature of the battery while the vehicle is driven, R is a gas constant, t is time, and n is a constant that is predetermined by a degradation speed of the battery according to the time).
The calculation unit may calculate the SOC with an accumulated amount of current flowing through at least one of a plurality of battery cells.
The calculation unit may calculate the first and second degradation capacities based on a standard capacity of the battery.
The determination unit may calculate the SOH by adding the first and second degradation capacities.

BRIEF DESCRIPTION OF THE DRAWINGS

Features will become apparent to those of skill in the art by describing in detail exemplary embodiments with reference to the attached drawings in which:

FIG. 1 illustrates a schematic drawing of a battery management apparatus according to an exemplary embodiment.
FIG. 2 illustrates a schematic drawing of the battery management unit to describe an overall SOH estimating method of a battery according to the exemplary embodiment.

DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art.

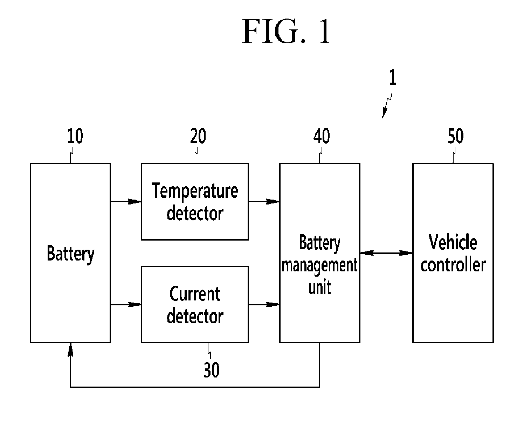

FIG. 1 illustrates a schematic drawing of a battery management apparatus according to an exemplary embodiment.
Referring to FIG. 1, a battery management apparatus 1 according to an exemplary embodiment includes: a battery 10 having a plurality of battery cells, a temperature detector 20, a current detector 30, a battery management unit 40, and a vehicle controller 50.
The temperature detector 20 includes a temperature sensor (not shown) that detects a temperature of the battery 10, and the current detector 30 includes a current sensor (not shown) that detects a current that flows through the battery 10.
The battery management unit 40 communicates with the vehicle controller 50 to receive information about a driving state of a vehicle, and receives information about temperature and current of the battery 10 from the temperature detector 20 and the current detector 30.
In addition, the battery management unit 40 uses the driving state of the vehicle and the temperature and current of the battery 10 to estimate an overall SOH of the battery 10. Depending on the estimated overall SOH, the battery management unit 40 determines a replacement time of the battery 10, and notifies a user thereof.
In detail, while the vehicle is driven, the battery management unit 40 uses the temperature of the battery 10 to calculate a degradation capacity $Q_d$ (hereinafter referred to as "a first degradation capacity") of the battery 10 at every unit time The calculation is accomplished by a calculation unit 46 of the battery management unit 40. Here, the unit time may be a predetermined time interval for calculating the degradation capacity $Q_d$ for example, one hour. In addition, while the vehicle is parked, the battery management unit 40 uses the temperature and an idle SOC of the battery 10 to calculate a degradation capacity $Q_p$ (hereinafter referred to as a "second degradation capacity") of the battery 10 at every unit time. The calculation is accomplished also by the calculation unit 46 of the battery management unit 40. The calculation unit 46 will in detail explained below. Here, the unit time may be a predetermined time interval for calculating the degradation capacity $Q_p$ for example, one hour.
While the vehicle is parked, the temperature of the battery 10 may correspond to an ambient temperature of the battery 10, that is, an external temperature thereof.
Further, the battery management unit 40 estimates the overall SOH of the battery 10 depending on a sum of the calculated first and second degradation capacities $Q_d$ and $Q_p$.
The vehicle controller 50 determines the current driving state of the vehicle based on information such as from an accelerator, a brake, and a speed of the vehicle, and controls driving of a motor (not shown) according to the driving state of the vehicle.
Herein, the driving state of the vehicle may include a key-on state for turning on the engine, a key-off state for turning off the engine, a cruise driving state, an acceleration driving state, etc.

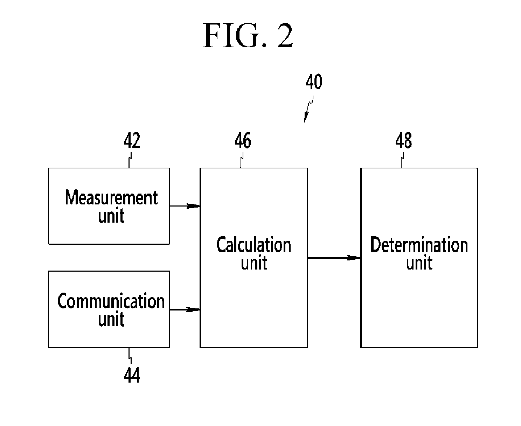

FIG. 2 illustrates a schematic drawing of the battery management unit to describe an overall SOH estimating method of a battery according to the exemplary embodiment.
Referring to FIG. 2, the battery management unit 40 according to the exemplary embodiment includes a measurement unit 42, a communication unit 44, a calculation unit 46, and a determination unit 48.
The measurement unit 42 measures the temperature and current of the battery 10 at every predetermined unit time through the temperature detector 20 and the current detector 30 and to transmits the measured temperature and current values to the calculation unit 46.
The communication unit 44 communicates with the vehicle controller 50 to receive the information about the driving state of the vehicle, and transmits the information to the calculation unit 46.
The calculation unit 46 determines whether the vehicle is driven or parked depending on the information about the driving state of the vehicle.

The calculation unit 46 calculates the first degradation capacity Qd of the battery 10 according to the following Equation 1.

[Equation 1]

$$Qd = Bd \times e^{-\frac{Ea}{R \times Tb}} \times t^{n}$$

Herein, Bd and Ea are pre-calculated values as a result of testing of at least one test or reference battery cell by using a measured value of a reference or standard discharge capacity of the battery cell with a standard discharge capacity. The unit of Qd is Ah(ampere hour), the unit of Bd is Ah*(seconds)^(-n), the unit of Ea is J/mol, the unit of R is J/(mol*K), the unit of Tb is K, and the unit of t is seconds.

For example, an accumulated amount of the current, which is measured while the test battery cell is discharged from 4.1 V to 2.7 V at 1/3 C, is set to the measured value of the standard discharge capacity.

Bd denotes a slope corresponding to a current temperature of the battery 10 in a function showing varying degradation capacities according to varying temperatures based on the measured value of the standard discharge capacity of the test battery cell.

Ea denotes an activation energy corresponding to a current temperature of the battery 10.

Tb is the temperature of the battery 10, R is a gas constant, and t is time. n is a preset constant to allow for a slowed degradation process of the battery cell as time passes.

In addition, while the vehicle is parked, the calculation unit 46 calculates the second degradation capacity Qp of the battery 10 according to the following Equation 2.

[Equation 2]

$$Qp = Bp \times e^{-\frac{Ea}{R \times Tb}} \times t^{n}$$

The unit of Qp is Ah(ampere hour), the unit of Bp is Ah*(seconds)^(-n), the unit of Ea is J/mol, the unit of R is J/(mol*K), the unit of Tb is K, and the unit of t is seconds.

Herein, Bp denotes a slope of a function calculated by using the idle SOC, which is the accumulated amount of the current of the battery 10. The idle SOC refers to the SOC of the battery 10 in the idle state of the vehicle due to parking thereof.

The determination unit 48 uses the first and second degradation capacities Qd and Qp to calculate the overall SOH of at least one of a plurality of battery cells in the battery 10. The determination unit 48 may add the first and second degradation capacities Qd and Qp to calculate the overall SOH. In order to estimate the overall SOH, the determination unit 48 may use the first degradation capacity Qd that is accumulated at every unit time while the vehicle is driven, and the second degradation capacity Qp that is accumulated at every unit time while the vehicle is parked.

In addition, depending on the overall SOH value, the determination unit 48 may estimate a lifespan of the battery 10 and determine the replacement time of the battery 10 so as to notify a user of the replacement time of the battery 10.

For example, the determination unit 48 may calculate a remaining period after which the SOH of the battery 10 falls below a predetermined reference value under a condition that the vehicle is continuously driven or parked, and may determine the corresponding remaining period until the battery 10 should be replaced.

By way of summation and review, a vehicle using electrical energy may be affected by the performance of its battery. Accordingly, a battery management system (BMS) is desirable to estimate a state of charge (SOC), a state of health (SOH), etc., and to efficiently manage charging/discharging and lifespan of the battery.

Embodiments provide a battery management apparatus that may calculate a state of health (SOH) of a battery in real time to estimate a lifespan of the battery while a vehicle is driven or parked. An exemplary embodiment uses the temperature of the battery while the vehicle is driven and the ambient temperature and the SOC while the vehicle is parked so as to calculate the overall SOH of the battery in real time, such that the SOH may be estimated with a simple control logic and the degradation of the battery may be determined such that the lifespan of the battery at low and room temperatures in addition to at a high temperature may be correctly estimated.

The methods and processes described herein may be performed by code or instructions to be executed by a computer, processor, or controller. Because the algorithms that form the basis of the methods are described in detail, the code or instructions for implementing the operations of the method embodiments may transform the computer, processor, or controller into a special-purpose processor for performing the methods described herein.

Also, another embodiment may include a computer-readable medium, e.g., a non-transitory computer-readable medium, for storing the code or instructions described above. The computer-readable medium may be a volatile or non-volatile memory or other storage device, which may be removably or fixedly coupled to the computer, processor, or controller which is to execute the code or instructions for performing the method embodiments described herein.

**Claims**

1. A battery management apparatus (1) to manage a battery (10) in a vehicle, the battery management apparatus comprising:

   a temperature detector (20) that detects a temperature of the battery (10);
   a current detector (30) that detects a current of the battery (10);
   a calculation unit (46) that calculates a first degradation capacity (Qd) using the detected temperature of the battery (10) at every unit time while the vehicle is driven and that calculates a second degradation capacity (Qp) using the detected temperature and state of charge (SOC) of the battery (10) at every unit time while the vehicle is parked; and
   a determination unit (48) that calculates a state of health (SOH) of the battery (10) using the first and second degradation capacities (Qd, Qp) so as to determine a replacement time of the battery according to the calculated SOH.

2. The apparatus as claimed in claim 1, wherein the calculation unit (46) is configured to calculate the first degradation capacity (Qd) according to the following Equation 1:

   [Equation 1]

   $$Qd = Bd \times e^{-\frac{Ea}{R \times Tb}} \times t^{n}$$

   where Bd denotes a slope of a function showing a degradation degree of a reference capacity of the battery according to a varying temperature of the battery, Ea is an activation energy corresponding to a current temperature of the battery, Tb is a temperature of the battery while the vehicle is driven, R is the gas constant, t is time, and n is a constant that is predetermined by a degradation speed of the battery according to time.

3. The apparatus as claimed in claim 1 or 2, wherein the calculation unit (46) is configured to calculate the second degradation capacity according to the following Equation 2:

[Equation 2]

$$Qp = Bp \times e^{-\frac{Ea}{R \times Tb}} \times t^{n}$$

where Bp is a function with the SOC of the battery as a variable, Ea is an activation energy corresponding to a current temperature of the battery, Tb is a temperature of the battery while the vehicle is driven, R is the gas constant, t is time, and n is a constant that is predetermined by a degradation speed of the battery according to the time.

4. The apparatus as claimed in one of the preceding claims, wherein the calculation unit (46) is configured to calculate the SOC using an accumulated amount of current flowing through at least one of a plurality of battery cells in the battery (10).

5. The apparatus as claimed in one of the preceding claims, wherein the calculation unit (46) is configured to calculate the first and second degradation capacities (Qd, Qp) based on a reference capacity of the battery.

6. The apparatus as claimed in one of the preceding claims, wherein the determination unit (48) is configured to calculate the SOH by adding the first and second degradation capacities (Qd, Qp).

7. The apparatus as claimed in one of the preceding claims, further comprising a vehicle controller (50) determining a current driving state of the vehicle,
wherein the current driving state of the vehicle includes a key-on state for turning on the engine, a key-off state for turning off the engine, a cruise driving state, and an acceleration driving state.

8. The apparatus as claimed in one of the preceding claims, further comprising a measurement unit (42) measuring the temperature and current of the battery (10) at every unit time through the temperature detector (20) and current detector (30) and transmitting the measured temperature and current values to the calculating unit (46).

9. The apparatus as claimed in 7 or 8, further comprising a communication unit communicating with the vehicle controller (50) to receive the information about the driving state of the vehicle and transmitting to the calculating unit (46).

# FIG. 1

# FIG. 2

40

42

46

48

| Measurement unit |
|---|

| Communication unit |
|---|

44

| Calculation unit |
|---|

| Determination unit |
|---|